# EUROPEAN PATENT APPLICATION

(11) **EP 1 519 226 A2**
(43) Date of publication of application: **30.03.2005**
(21) Application number: 04022332.3
(22) Date of filing: 20.09.2004
(51) Int. Cl.: G03F 1/16, H01J 37/317

(54) **Stencil mask, production method thereof, exposure apparatus, exposure method and electronic device production method**

(30) Priority: 29.09.2003 JP 2003337025
(71) Applicant: SONY CORPORATION, Tokyo (JP)
(72) Inventor: Nohama, Shoji, Sawara-ku Fukuoka-shi Fukuoka (JP)
(74) Representative: Müller - Hoffmann & Partner

(57) **Abstract**

A stencil mask capable of effectively reducing a dimension of apertures to be a mask pattern while preventing damages on a pattern formation layer and variations of positional accuracy of the apertures, and the production method, and an exposure apparatus and an exposure method capable of performing exposure of a fine pattern on a layer to be exposed by using the stencil mask, and a production method of an electronic device are provided: wherein a dimension control layer is formed on all surface of the pattern formation layer including apertures for a charged particle beam to transmit by an isotropic film forming method, so that a dimension of the apertures to be a mask pattern substantially is reduced exactly by a film thickness amount of the dimension control layer from a dimension of apertures formed by using a mask drawing machine; and it is preferable that the dimension control layer has conductivity and is made of a material having an approximately same linear expansion coefficient with that of the pattern formation layer.

## Description

### BACKGROUND OF THE INVENTION

### 1. Field of the Invention

The present invention relates to a stencil mask for lithography using a charged particle beam, the production method, an exposure apparatus and an exposure method using the stencil mask, and an electronic device production method.

### 2. Description of the Related Art

In recent years, as an integrated circuit becomes higher in density, limitations have been pointed out on photolithography which has been a mainstream of fine pattern formation techniques. To overcome the limitations, lithography by an electron beam (an electron beam exposure apparatus) has been rapidly advanced.

Particularly in an electron beam projection exposure apparatus and an electron beam proximity exposure apparatus, a mask having a thin membrane having a thickness of 300 nm to 2 µm formed by SiC, Si or diamond is used. In the mask production method, by applying a resist to the membrane layer, transferring a pattern by an electron beam or a laser, etc., developing, and performing etching on the membrane layer by using the resist as a mask, a mask pattern is formed (refer to the patent articles 1 to 4).

Particularly, a mask used in the electronic beam proximity exposure apparatus is an unmagnified mask. Therefore, when drawing by an electron beam or laser for producing a mask, mask drawing at high resolution of, for example, 100 nm or less, that is, patterning for etching processing of the mask is required. It is necessary to use the latest drawing machine for producing such a pattern, but those satisfying the specification are few, and if any, they are very expensive. Furthermore, it is also required to produce a pattern exceeding resolution limitations of the mask drawing machine due to miniaturization, which is naturally impossible to attain with the mask drawing machine.

To eliminate the above disadvantages, an improvement of performance of the resist and higher performance of the mask drawing machine are necessary for mask processing. The former is largely affected by the latter, and an improvement of the resist performance peaks out because it largely depends on an effect of a latent image by the electron beam to the resist. Also, the latter faces a high technical obstacle and results in a very expensive apparatus even if it is overcome.

To obtain a fine resist pattern for mask processing of more than performance of the mask drawing machine, a method of forming a fine resist pattern by thermally contracting the resist pattern has been proposed (refer to patent articles 5 and 6).

Also, a method of effectively miniaturizing a trench pattern and a hole pattern than the resolution limitations by providing a covering layer on the resist pattern and making the resist pattern thicker by cross-linking the covering layer has been proposed (refer to patent article 7).

Alternately, a method of making a resist pattern finer by after applying a positive resist on a resist pattern for electron beam resist, such as polymethylmethacrylate, providing a reactive layer on a boundary of the resist pattern and the positive resist layer by performing heat treatment, and removing a non reactive portion of the positive resist has been proposed (refer to patent article 8).

Similarly, as a method of shrinking a resist, a method of forming a reactive layer by using thermal cross-linking due to an acid-forming agent and acid between a lower layer resist pattern and an upper layer resist has been proposed (refer to the patent article 9). Also, a method of using as an upper layer resist coating solution a fine pattern forming material not including photosensitive components, obtained by dissolving a water-soluble resin, a water-soluble cross-linker, or a mixture of the two has been proposed (refer to the patent article 10).

Furthermore, as a method of shrinking a resist, a method of applying on a resist pattern a coating film forming agent including a water-soluble resin, such as polyvinyl acetal, a water-soluble cross-linker, such as tetra(hydroxymethyl)glycoluril, a water-soluble nitride contained organic compound, such as amine, and in accordance with need, fluorine and silica-contained surfactant has been proposed (refer to the patent article 11). In this method, heat treatment is performed after coating to form a water-insoluble reactive layer on a boundary surface of the resist pattern and the coating film, then, non reactive portions of the coating film is removed by a solvent.
[Patent Article 1] The Japanese Unexamined Patent Publication No. 2002-231599
[Patent Article 2] The Japanese Unexamined Patent Publication No. 2002-252157
[Patent Article 3] The Japanese Unexamined Patent Publication No. 2002-270496
[Patent Article 4] The Japanese Unexamined Patent Publication No. 2002-343710
[Patent Article 5] The Japanese Unexamined Patent Publication No. 2003-84459
[Patent Article 6] The Japanese Unexamined Patent Publication No. 2003-84460
[Patent Article 7] The Japanese Unexamined Patent Publication No. 2001-19860
[Patent Article 8] The Japanese Patent No. 2723260
[Patent Article 9] The Japanese Unexamined Patent Publication No. 6-250379
[Patent Article 10] The Japanese Unexamined Patent Publication No. 10-73927
[Patent Article 11] The Japanese Unexamined Patent Publication No. 2000-347414
[Patent Article 12] The Japanese Unexamined Patent Publication No. 1-307228
[Patent Article 13] The Japanese Unexamined Patent Publication No. 4-364021
[Patent Article 14] The Japanese Unexamined Patent Publication No. 7-45510

These methods are preferable because a finer pattern can be easily obtained by a fine pattern formation material (an upper layer resist) exceeding the wavelength limit of a photosensitive resist (a lower resist). However, there are disadvantages that cross-linking of the fine pattern formation material arises also in an unnecessary portion of the bottom part of the resist pattern, perpendicularity of a sectional shape of the fine pattern formation material becomes defective, or a dimension of an upper resist pattern varies due to mixing bake for inducing cross-linking. Also, the processes exhibit high heat dependency of 10 to 19 nm/C°, and it is hard to maintain a uniform temperature on the wafer when the substrate becomes larger and the pattern becomes finer, so that there is a disadvantage that controllability of a dimension of an obtained pattern declines.

Other than the above, a so-called thermal flow process for making the pattern dimension smaller than the resolution limit by forming a photoresist pattern on a substrate first, performing heat or radiation ray irradiation thereon, and fluidizing the photoresist pattern has been proposed (refer to the patent article 12 and 13). However, this method has a disadvantage that control of fluidity of the resist by heat or a radiation ray is difficult and products with consistent quality cannot be obtained.

Furthermore, as an advanced method of the thermal flow process, a method for controlling fluidity of a photoresist by forming a photoresist pattern on a substrate and providing a water-soluble resin film thereon has been proposed (refer to the patent article 14). However, the water-soluble resin, such as polyvinyl alcohol, used in the method has a disadvantage that solubility and stability over time required at being removed by water are insufficient and residual is generated.

On the other hand, in the method of shrinking the resist explained above, a membrane is highly liable to be damaged, for example, by being imposed a compression stress on apertures and a contraction stress on resist portions when subjected to heat contraction, etc. Also, there is a disadvantage that positional accuracy of apertures is deteriorated by internal stress variation of the membrane. Thus, it may be applied to a wafer process, but hard to be applied to a stencil mask covered by the present invention.

### SUMMARY OF THE INVENTION

An object of the present invention is to provide a stencil mask capable of effectively reducing a dimension of apertures to be a mask pattern while preventing damages on a pattern formation layer and variation of positional accuracy of the apertures, and the production method.

Another object of the present invention is to provide an exposure apparatus and an exposure method capable of performing exposure of a fine pattern on a layer to be exposed by using the above stencil mask, and a production method of an electronic device.

To attain the above object, according to the present invention, there is provided a stencil mask, comprising a pattern formation layer formed with a pattern comprising apertures for a charged particle beam to transmit; and a dimension control layer covering at least inner walls of the apertures to reduce a dimension of the pattern.

In the stencil mask of the present invention as above, the dimension control layer covering the inner walls of the apertures formed on the pattern formation layer reduces a dimension of the apertures, consequently, a dimension of a pattern comprising the apertures is reduced.

To attain the above object, according to the present invention, there is provided a production method of the stencil mask comprising the steps of forming a pattern comprising apertures for a charged particle beam to transmit on a pattern formation layer; and forming a dimension control layer covering at least inner walls of the apertures to reduce a dimension of the pattern.

In the production method of the stencil mask of the present invention as above, the dimension control layer covering the inner walls of the apertures formed on the pattern formation layer reduces a dimension of the apertures, consequently, a dimension of a pattern comprising the apertures is reduced. Therefore, in the step of forming a pattern comprising apertures on the pattern formation layer, although there is a limit on a dimension of the apertures formed on the pattern formation layer in terms of processing accuracy, a dimension of the pattern is furthermore reduced by forming the dimension control layer later.

To attain the above object, according to the present invention, there is provided an exposure apparatus, comprising an irradiation portion of a charged particle beam and a stencil mask provided to a path of the charged particle beam irradiated from the irradiation portion: wherein the stencil mask comprises a pattern formation layer formed with a pattern comprising apertures for a charged particle beam to transmit; and a dimension control layer covering at least inner walls of the apertures to reduce a dimension of the pattern.

In the exposure apparatus of the present invention as above, the charged particle beam incident on the stencil mask transmits apertures downsized exactly by the film thickness amount of the dimension control layer from the apertures on the pattern formation layer. As a result, a pattern to be exposed on the layer to be exposed is smaller exactly by the film thickness amount of the dimension control layer than the apertures formed on the pattern formation layer.

To attain the above object, according to the present invention, there is provided an exposure method for exposing a pattern of a stencil mask on a layer to be exposed by irradiating a charged particle beam to the stencil mask: wherein the charged particle beam is irradiated to the stencil mask comprising a pattern formation layer formed with the pattern comprising apertures for a charged particle beam to transmit, and a dimension control layer covering at least inner walls of the apertures to reduce a dimension of the pattern.

In the exposure method of the present invention as above, when a charged particle beam is irradiated on the stencil mask, the charged particle beam transmits through apertures which are narrowed exactly by the film thickness amount of the dimension control layer from the apertures of the pattern formation layer.

To attain the above object, according to the present invention, there is provided a production method of an electronic device, including an exposure step for forming an exposure pattern on a layer to be exposed by performing exposure by using a stencil mask, and a pattern processing step for etching on a pattern layer composing an electronic device by using the layer to be exposed as an etching mask: wherein in the exposure step, a charged particle beam is irradiated to a stencil mask comprising a pattern formation layer formed with a pattern comprising apertures for a charged particle beam to transmit, and a dimension control layer covering at least inner walls of the apertures to reduce a dimension of the pattern.

In the production method of an electronic device of the present invention as above, in the exposure step, an exposure pattern to be exposed on the layer to be exposed is smaller exactly by the film thickness amount of the dimension control layer than the apertures formed on the pattern formation layer. Accordingly, a dimension of a pattern layer subjected to etching processing using the exposure layer as an etching mask is reduced.

According to the stencil mask and the production method of the present invention, a stencil mask wherein a dimension of apertures to be a mask pattern is effectively reduced can be realized while preventing damages on the pattern formation layer and variation of positional accuracy of the apertures. According to the exposure apparatus of the present invention using the above stencil mask, a fine pattern can be exposed on the layer to be exposed. Also, according to the production method of an electronic device of the present invention, a pattern layer of the electronic device can be made finer, and a more compact and further integrated electronic device can be attained.

### BRIEF DESCRIPTION OF DRAWINGS

These and other objects and features of the present invention will become clearer from the following description of the preferred embodiments given with reference to the attached drawings, in which:
FIG. 1 is a view of the schematic configuration of an electron beam exposure apparatus according to the present embodiment;
FIG. 2 is a perspective view of a key part of a stencil mask;
FIG. 3 is a sectional view of a key part of a pattern formation layer;
FIG. 4 is a perspective view of a key part of mask blanks;
FIG. 5A to FIG. 5H are sectional views of production steps of the stencil mask according to the present embodiment; and
FIG. 6A to FIG. 6D are sectional views of a key part of the pattern formation layer in the production steps of the stencil mask according to the present embodiment.

### DESCRIPTION OF THE PREFERRED EMBODIMENT

Below, an embodiment of the present invention will be explained with reference to the drawings. Note that in the present embodiment, an explanation will be made on a stencil mask used in the LEEPL as an example, the production method, an exposure apparatus, an exposure method and a production method of an electronic device, but the present invention is not limited to the explanation.

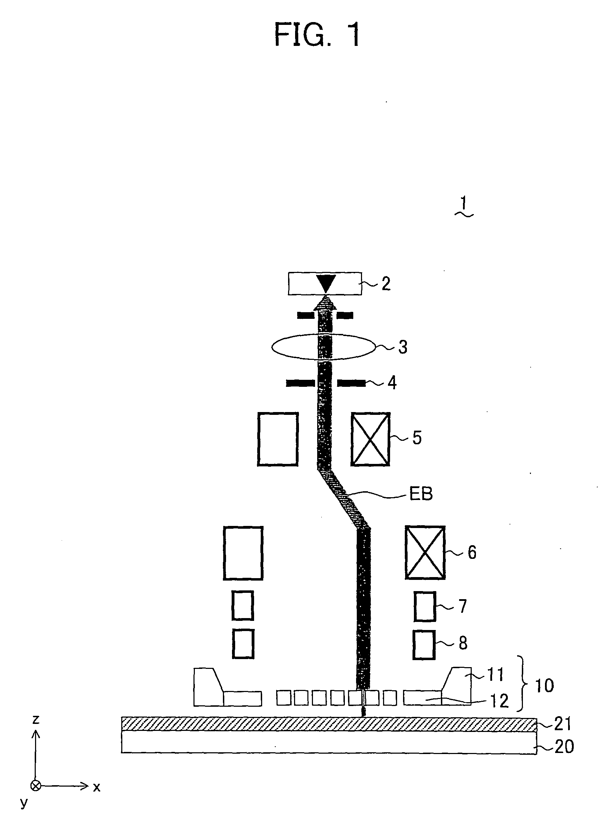

FIG. 1 is a view of the schematic configuration of an electron beam exposure apparatus according to the present embodiment.

The electron beam exposure apparatus 1 comprises an electron gun 2 for emitting an electron beam EB as an exposure beam. A stencil mask 10 is arranged in a state where a path of the electron beam EB emitted from the electron gun 2 is a normal. By keeping a distance from the stencil mask 10, a substrate under processing 20, such as a wafer, is arranged on a not shown stage being movable in the xy-direction. On a surface of the substrate 20, a layer to be exposed 21 made by an electron beam resist is formed. The substrate 20 is arranged to provide a distance of about 50 µm between the surface of the substrate 20 and a surface of the stencil mask 10.

Between the electron gun 2 and the stencil mask 10, a condenser lens 3, an aperture 4, a pair of main deflectors 5 and 6, and a pair of sub deflectors 7 and 8 are provided in this order from the electron gun 2 side in a state of surrounding the path of the electron beam EB. The condenser lens 3 makes the electron beam EB parallel, and the aperture 4 shapes the electron beam EB. The pair of main deflectors 5 and 6 perform raster scan or vector scan on the stencil mask 10 with the parallel electron beam EB. The pair of sub deflectors 7 and 8 adjust an incident angle of the electron beam to the stencil mask 10 and finely adjust an irradiation position of the electron beam.

The stencil mask 10 is a mask formed with a mask pattern comprising apertures (through holes), wherein the sides are supported by a supporting frame 11 and apertures to be a mask pattern is formed on a pattern formation layer 12 which is a thin film surrounded by the supporting frame 11.

When performing exposure by using an exposure apparatus configured as above, first, the substrate 20 formed with the layer to be exposed 21 on its surface is mounted on the not shown stage. Next, an electron mean EB emitted from the electron gun 2 is irradiated on the stencil mask 10 by scanning while shaping the electron beam EB by the condenser lens 3 and the aperture 4 and adjusting the irradiation position thereof by the above deflectors 5 to 8. As a result that the electron beam transmitted through the mask pattern comprising apertures on the stencil mask 10 is irradiated on the layer to be exposed 21 of the substrate 20, pattern exposure is performed on the layer to be exposed 21 (an exposure step).

When the layer to be exposed 21 is a positive electron beam resist, portions irradiated with the electron beam are dissolved in the later development. Alternately, when the layer to be exposed 21 is a negative electron beam resist, the portions irradiated with the electron beam remain in the later development.

When producing an electron device, an exposure layer formed with an exposure pattern as explained above is used as an etching mask to performing etching processing on a lower layer, and a pattern layer is formed (a pattern processing step). By repeating the above exposure step and the pattern processing step, the pattern layer is integrated and the electron device is produced.

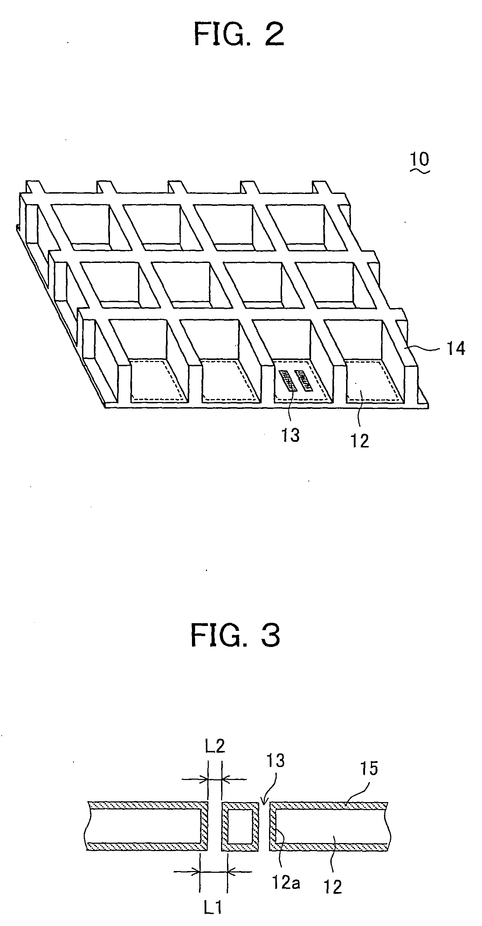

FIG. 2 is a perspective view of a key part of the stencil mask.

Apertures 13 to be a mask pattern are formed on the pattern formation layer 12 of the stencil mask 10. A film thickness of the pattern formation layer 12 is 300 nm to 2 µm or so. The pattern formation layer 12 is composed of, for example, Si, SiC or diamond.

To reinforce the strength of the pattern formation layer 12 as a thin film, reinforcing beam portions 14 in a lattice shape are formed. The reinforcing beam portions 14 are composed of, for example, Si and the film thickness is 700 µm or so.

FIG. 3 is a sectional view of a key part of the pattern formation layer 12.

The pattern formation layer 12 is formed with apertures 12a, and a dimension control layer 15 is formed allover the pattern formation layer 12 including inner walls of the apertures 12a. The dimension control layer 15 is not formed only on one surface of the pattern formation layer, but on the whole surface including the apertures 12a of the pattern formation layer 12, that is, the film is formed to be isotropic.

The dimension control layer 15 is preferably formed by a conductive material. It is to prevent charge-up due to a charged particle beam, because a charged particle beam, such as an electron beam, is irradiated to the stencil mask 10. Accordingly, it is preferable to use, for example, polysilicon, tungsten, titanium, tungsten silicide, titanium silicide, molybdenum silicide, and cobalt silicide for the pattern formation layer 12.

Also, the dimension control layer 15 is preferably formed by a material having a linear expansion coefficient close to that of the pattern formation layer 12. It is because when the linear expansion coefficients are different, the pattern formation layer 12 bends and positions of apertures move. For example, when the pattern formation layer 12 is formed by single crystal silicon, it is preferable to use polysilicon for the dimension control layer 15.

When assuming that a dimension of apertures 12a formed on the pattern formation layer 12 is L1, apertures 13 having a reduced dimension exactly by a film thickness amount of the dimension control layer 15 covering the inner walls of the apertures 12a are obtained. A line width of the apertures 13 becomes a final line width of the mask pattern.

For example, when the dimension L1 of the aperture 12a is 70 to 80 nm or so, by setting the film thickness of the dimension control layer 15 to be 10 nm or so, a substantial dimension L2 of the aperture 13 becomes 50 to 60 nm or so.

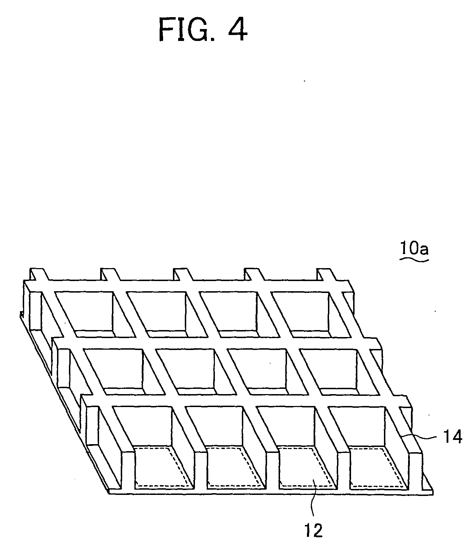

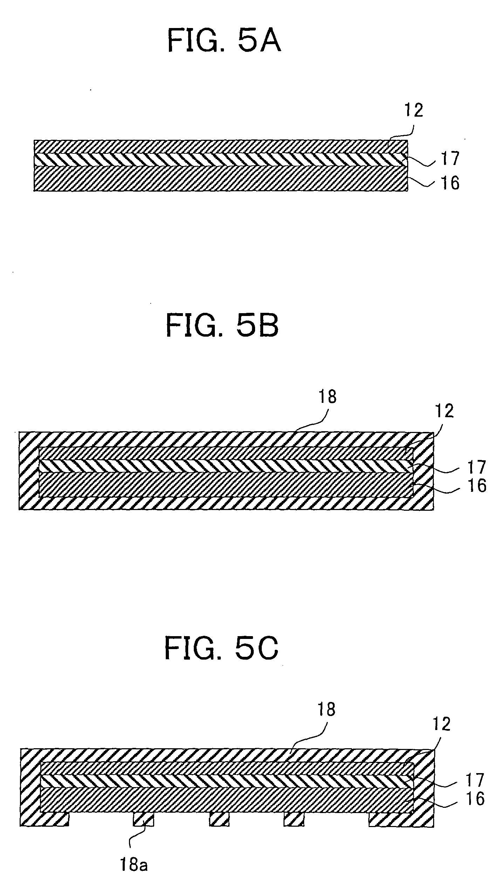

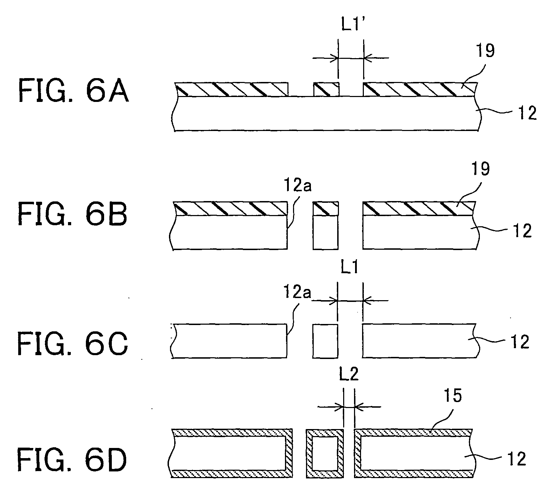

Next, a production method of the stencil mask according to the present embodiment as above will be explained with reference to the drawings. FIG. 4 is a perspective view of mask blanks used in producing the stencil mask according to the present embodiment. FIG. 5A to FIG. 5H are sectional views of whole production steps of the stencil mask according to the present embodiment. FIG. 6A to FIG. 6D are sectional views of a key part of the pattern formation layer in the production steps of the stencil mask according to the present embodiment.

As shown in FIG. 4, mask blanks 10a formed with a pattern formation layer 12 and reinforcing beam portions 14 for reinforcing the strength of the pattern formation layer 12 is prepared. Note that there are a variety of methods as a production method of the mask blanks 10a, but an example of using a SOI substrate will be explained in the present embodiment.

Namely, as shown in FIG. 5A, a SOI substrate obtained by forming a silicon oxide film on a single crystal silicon substrate and forming a thin silicon layer on the silicon oxide layer is used. The single crystal silicon substrate of the SOI substrate is used as a supporting substrate 16, the silicon oxide film of the SOI substrate is used as a stopper layer 17, and a silicon layer of the SOI substrate is used as a pattern formation layer 12.

Next, as shown in FIG. 5B, a film of Si₃N₄ is formed over the whole surfaces including the front surface and the back surface of the SOI substrate, for example, by the low pressure chemical vapor deposition (LPCVD) method to form a hard mask 18. A film thickness of the hard mask 18 is, for example, 400 nm or so.

Next, on the hard mask 18 on the back surface side (the supporting substrate 16 side) of the SOI substrate, resist coating, electron beam drawing and development are performed. Continuously, as shown in FIG. 5C, by performing dry etching on the hard mask 18 by using a resist as an etching mask, a hard mask 18a having a pattern of the reinforcing beam portions and a supporting frame is formed. In the etching on the hard mask 18, for example, a fluorocarbon-based gas is used. Then, the resist is removed.

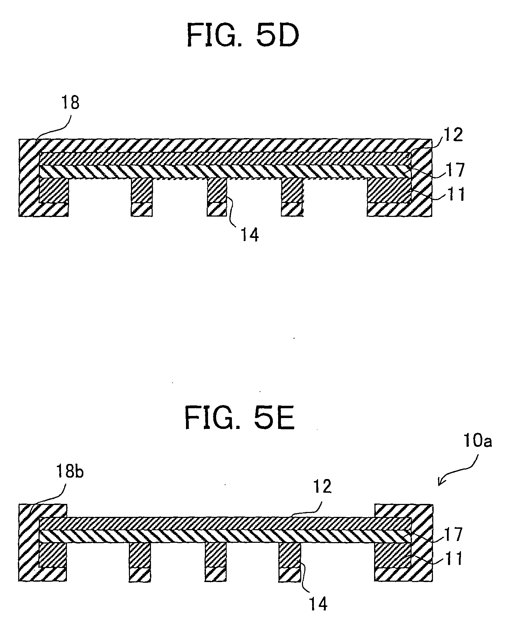

Next, as shown in FIG. 5D, etching is performed on the supporting substrate 16 until reaching to the stopper layer 17 by using the hard mask 18a as an etching mask, and a supporting frame 11 and reinforcing beam portions 14 are formed. In the etching on the supporting substrate 16, for example, a chlorine-based gas is used.

Next, on the hard mask 18 on the front surface side (the pattern formation layer 12 side) of the SOI substrate, resist coating, electron beam drawing and development are performed. Continuously, as shown in FIG. 5E, by performing dry etching on the hard mask 18 by using the resist as an etching mask, a hard mask 18b having a pattern with portions to be exposure regions is obtained. In the etching on the hard mask 18, for example, a fluorocarbon-based gas is used. Then, the resist is removed.

In the present embodiment, what produced by the above steps is used as the mask blanks 10a. Note that those produced by steps other than the above may be also used as the mask blanks 10a.

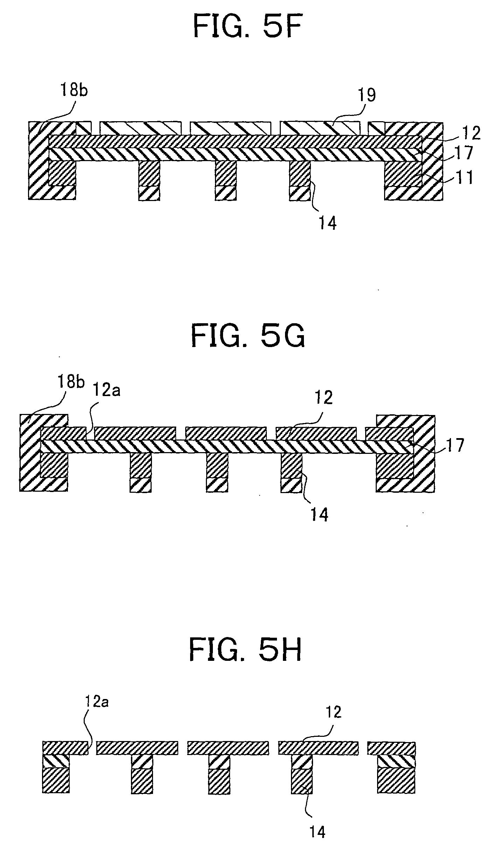

Next, as shown in FIG. 5F, an exposure layer 19 made by a resist is formed on the pattern formation layer 12 of the mask blanks 10a. Continuously, by performing exposure on the exposure layer 19 by using a mask drawing machine and developing, an exposure layer 19 having an exposure pattern is formed. As shown in FIG. 6A, a dimension L1' of the exposure pattern is limited by performance of the exposure layer 19 and performance of the mask drawing machine.

Next, as shown in FIG. 6B, by performing dry etching on the pattern formation layer 12 by using the exposure layer 19 as an etching mask, apertures 12a are formed on the pattern formation layer 12. In the etching on the pattern formation layer 12, for example, a chlorine-based gas is used. After that, as shown in FIG. 6C, the exposure layer 19 is removed. At this time, a dimension L1 of the apertures 12a formed on the pattern formation layer 12 is determined by a dimension L1' of the exposure pattern of the exposure layer 19 shown in FIG. 6A. As a result, as shown in FIG. 5G, apertures 12a reaching to the stopper layer 17 are formed. The stopper layer 17 becomes an etching stopper.

Next, as shown in FIG. 5H, the stopper layer 17 exposed from the reinforcing beam portions 14 is removed by etching, furthermore, the hard mask 18b is removed. In the etching on the stopper layer 17 made by oxide silicon, for example, a fluorocarbon-based gas is used.

From the above steps, a stencil mask formed with apertures 12a is produced.

Next, as shown in FIG. 6D, a dimension control layer 15 is formed allover the surfaces of the pattern formation layer 12 including the apertures 12a by an isotropic film forming method. Consequently, a dimension L2 of apertures 13 to be a mask pattern substantially is reduced exactly by a film thickness amount of the dimension control layer 15 from the dimension L1 of the apertures 12a formed by using the mask drawing machine.

When forming the dimension control layer 15, an isotropic film forming method, such as the LPCVD and plasma CVD, is used and, for example, polysilicon is used as a film formation material. When forming a polysilicon film by the LPCVD, a condition with a degree of vacuum of 0.3 Pa or less and a film forming temperature of 550°C or more is preferable in terms of keeping the isotropy.

Also, in an isotropic film forming method, such as the LPCVD and CVD, controllability of a film thickness in the stencil mask can be secured, so that the film thickness of the dimension control layer 15 does not largely vary between the center portion and edges.

Also, it is preferable that the dimension control layer 15 has conductivity for suppressing charge-up at electron beam exposure, conductivity is given by doping boron, phosphorous, and arsenic, etc. during the film formation. Alternately, conductivity is given after the film formation by doping boron, phosphorous, arsenic, etc. into the film by the liquid phase diffusion, solid phase diffusion or ion implantation. Note that since the methods of doping after the film formation require heat treatment, it is preferable to dope during the film formation in terms of reducing deformation of the pattern formation layer 12. Also, the doping becomes directional in ion implantation, doping during the film formation is preferable to form a dimension control layer 15 having conductivity on its all surface.

As explained above, according to the stencil mask of the present embodiment, a mask pattern comprising the apertures 13 having a reduced dimension exactly by a film thickness amount of the dimension control layer 15 from that of the apertures 12a is formed by the dimension control layer 15 covering inner walls of the apertures 12a formed on the pattern formation layer 12.

According to the production method of the stencil mask according to the present embodiment, not by shrinking the resist but by forming a dimension control layer 15 by an isotropic film forming method after forming apertures 12a on the pattern formation layer 12, a dimension of the apertures 13 can be reduced. Accordingly, a dimension of the apertures 13 to be a mask pattern can be effectively reduced while preventing damages on the pattern formation layer and variation of positional accuracy of a pattern due to heat and liquid.

Therefore, to form a fine mask pattern, without introducing or developing an expensive mask drawing machine with a high technical barrier, it is possible to produce a stencil mask having a mask pattern with a dimension of a resolution limit of a mask drawing machine or finer, for example, 100 nm or less.

According to an exposure apparatus and an exposure method according to the present embodiment using the above stencil mask, a fine pattern can be exposed on a layer to be exposed. Also, according to a production method of an electron device of the present invention, a pattern layer of the electron device can be made finer, and a more compact and further highly integrated electronic device can be attained.

The present invention is not limited to the above embodiment.

Although an example of using an electron beam was explained, any charged particle beam, such as an ion beam, other than an electron beam can be applied in the same way in the present invention. Also, a production method of a stencil mask using a SOI substrate was explained, but the present invention is not limited to this. Furthermore, a stencil mask having reinforcing beam portions was explained, but a stencil mask without a reinforcing beam portion may be also applied in the same way.

Other than the above, a variety of modifications may be made within the scope of the present invention.

## Claims

1. A stencil mask, comprising
a pattern formation layer formed with a pattern comprising apertures for a charged particle beam to transmit; and
a dimension control layer covering at least inner walls of said apertures to reduce a dimension of said pattern.

2. A stencil mask as set forth in claim 1, wherein said dimension control layer is formed to be isotropic on all surface of said pattern formation layer including inner walls of said apertures.

3. A stencil mask, as set froth in claim 1, wherein said dimension control layer has conductivity.

4. A stencil mask as set forth in claim 1, wherein said dimension control layer is formed by a material having an approximately same linear expansion coefficient as that of said pattern formation layer.

5. A production method of a stencil mask, comprising the steps of:
forming a pattern comprising apertures for a charged particle beam to transmit on a pattern formation layer; and
forming a dimension control layer covering at least inner walls of said apertures to reduce a dimension of said pattern.

6. A production method of a stencil mask as set forth in claim 5, wherein
the step of forming a pattern on said pattern formation layer comprises the steps of
forming a layer to be exposed on said pattern formation layer;
forming an exposure pattern on said layer to be exposed by exposure; and
forming a pattern comprising said apertures on said pattern formation layer by etching using said layer to be exposed as an etching mask.

7. A production method of a stencil mask as set forth in claim 5, wherein
in the step of forming said dimension control layer, said dimension control layer is formed isotropically on all surface of said pattern formation layer including inner walls of said apertures by using an isotropic film forming method.

8. An exposure apparatus, comprising an irradiation portion of a charged particle beam and a stencil mask provided to a path of said charged particle beam irradiated from said irradiation portion, wherein
said stencil mask comprises
a pattern formation layer formed with a pattern comprising apertures for a charged particle beam to transmit; and
a dimension control layer covering at least inner walls of said apertures to reduce a dimension of said pattern.

9. An exposure method, for exposing a pattern of a stencil mask on a layer to be exposed by irradiating a charged particle beam to said stencil mask, wherein
said charged particle beam is irradiated to said stencil mask comprising a pattern formation layer formed with said pattern comprising apertures for a charged particle beam to transmit, and a dimension control layer covering at least inner walls of said apertures to reduce a dimension of said pattern.

10. A production method of an electronic device, comprising an exposure step for forming an exposure pattern on a layer to be exposed by performing exposure by using a stencil mask, and a pattern processing step for etching on a pattern layer composing an electronic device by using said layer to be exposed as an etching mask; wherein
in said exposure step, a charged particle beam is irradiated to a stencil mask comprising a pattern formation layer formed with a pattern comprising apertures for a charged particle beam to transmit, and a dimension control layer covering at least inner walls of said apertures to reduce a dimension of said pattern.
